# EUROPEAN PATENT APPLICATION

(11) **EP 4 498 409 A1**
(43) Date of publication of application: **29.01.2025**
(21) Application number: 24190317.8
(22) Date of filing: 23.07.2024
(51) Int. Cl.: H01L 21/60, H01L 23/485

(54) **SEMICONDUCTOR DEVICE WITH HYBRID ROUTING AND METHOD THEREFOR**

(30) Priority: 27.07.2023 US 202318360208
(71) Applicant: NXP USA, Inc., Austin TX 78735 (US)
(72) Inventor: Foong, Chee Seng, 5656AG Eindhoven (NL); Uehling, Trent, 5656AG Eindhoven (NL); Zhou, Tingdong, 5656AG Eindhoven (NL); Mason, Kristen LeAnne, 5656AG Eindhoven (NL)
(74) Representative: Hardingham, Christopher Mark

(57) **Abstract**

A method of manufacturing a semiconductor device is provided. The method includes forming a first non-conductive layer over a top side a semiconductor die and patterning the first non-conductive layer to form a collar structure surrounding an opening exposing a top surface of a bond pad. A second non-conductive layer is formed over the first non-conductive layer and exposed portions of the top side of the semiconductor die. The second non-conductive layer is different from the first non-conductive layer. The second non-conductive layer is patterned to expose the top surface of the bond pad and inner sidewalls of the of the collar structure surrounding the opening such that the second non-conductive layer does not contact the bond pad. A metal redistribution layer is formed over the second non-conductive layer and exposed top surface of the bond pad.

## Description

### Background

### Field

This disclosure relates generally to semiconductor device packaging, and more specifically, to a semiconductor device with a redistribution layer and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example semiconductor device having a redistribution layer in accordance with an embodiment.
FIG. 2 through FIG. 8 illustrate, in simplified cross-sectional views, the example semiconductor device taken along line A-A of FIG. 1 at various stages of manufacture in accordance with an embodiment.

### Detailed Description

Generally, there is provided, a semiconductor device with a redistribution layer. The semiconductor device includes a first non-conductive layer formed over a top passivation layer of a semiconductor die. The first non-conductive layer is patterned to form a collar structure surrounding an outer perimeter of an opening that exposes a top surface portion of a bond pad of the semiconductor die. The collar structure has an inner portion that contacts an outer region of the exposed bond pad surface and an outer portion that extends beyond the outer perimeter of the opening. The semiconductor device further includes a second non-conductive layer formed over the collar structure and exposed surface of the top of the semiconductor die. The second non-conductive layer is formed having a different formulation that that of the first non-conductive layer. For example, the first non-conductive layer may be formulated without sulfur or sulfur-based solvents (e.g., dimethyl sulfoxide). The second non-conductive layer is patterned to expose the top surface portion of the bond pad and inner sidewalls of the of the collar structure surrounding the opening. The collar structure is configured to prevent the second non-conductive layer from directly contacting the top surface of the bond pad. A conductive redistribution layer is formed over the patterned second non-conductive layer and exposed top surface of the bond pad such that a portion of an interconnecting trace is directly connected to the bond pad through the opening. By forming the redistribution layer bond pad connection with the surrounding collar structure in this manner, the semiconductor device can operate at higher voltages and exhibit superior reliability.

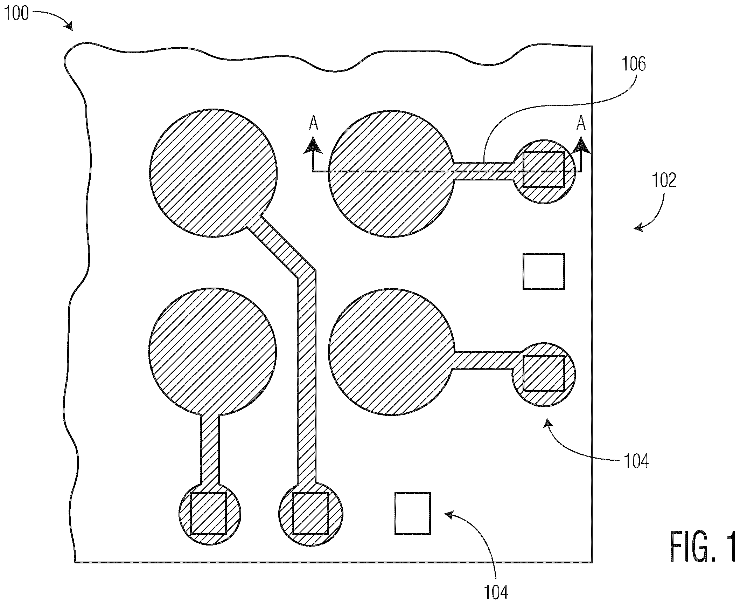

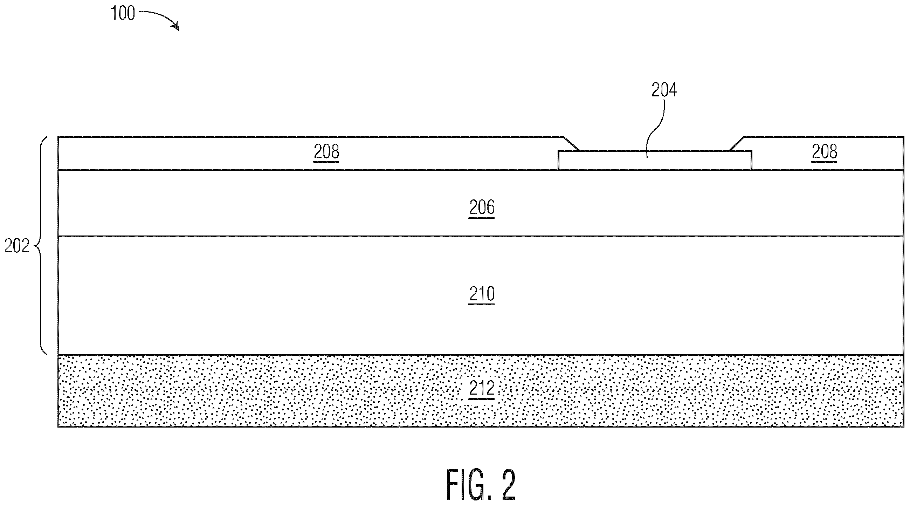

FIG. 1 illustrates, in a simplified plan view, a portion of an example semiconductor device 100 having a redistribution layer in accordance with an embodiment. The device 100 includes a semiconductor die 102, bond pads 104 formed at the top side of the semiconductor die, and conductive (e.g., metal) redistribution layer (RDL) formed over the semiconductor die. The term "conductive," as used herein, generally refers to electrical conductivity unless otherwise described. In this embodiment, the RDL is patterned to form a plurality of RDL interconnection traces 106. In this embodiment, each of the RDL interconnections traces 106 includes a first portion directly connected to a top surface of a respective bond pad 104 and a second portion configured as a base for formation of a respective under-bump metallization (UBM) structure at a subsequent stage of manufacture. The number, shape, and arrangement of die pads 104 and patterned RDL interconnection traces 106 are chosen for illustration purposes. Detailed features of the semiconductor device 100 such as intermediate layers disposed between the semiconductor die and the RDL are not shown for illustration purposes. Even though the embodiment of FIG. 1 is depicted in a "fan-in" configuration, embodiments in other configurations (e.g., "fan-out") are anticipated by this disclosure. Cross-sectional views of the example semiconductor device 100 taken along line A-A of FIG. 1 at stages of manufacture are depicted in FIG. 2 through FIG. 8.

FIG. 2 illustrates, in a simplified cross-sectional view, the example semiconductor device 100 at a stage of manufacture in accordance with an embodiment. At this stage of manufacture, a semiconductor die 202 may be at least partially encapsulated with an encapsulant (e.g., epoxy molding compound) 212. In this embodiment, the semiconductor die 202 includes a substrate region (e.g., bulk) 210, an active region (e.g., circuitry, interconnect) 206 formed at an active side of the semiconductor die, a bond pad 204 conductively connected to the circuitry and/or interconnect of the active region, and a final passivation layer 208 formed over the active side of the semiconductor die. In some embodiments, the semiconductor die 202 may be provided in a wafer form or portion of a wafer. In some embodiments (e.g., wafer-level chip-scale packaging), the semiconductor device 100 may be formed without encapsulant 212. The semiconductor die 202 may include any number of conductive interconnect layers and passivation layers. For illustration purposes, the bond pad 204 at a top surface and the overlying final passivation layer 208 are depicted. In this embodiment, the semiconductor die 202 depicted in FIG. 2 corresponds to the semiconductor die 102 of FIG. 1.

The semiconductor die 202 is configured and arranged in an active side up orientation. The bond pad 204 at the active side is configured for connection to printed circuit board (PCB) by way of a redistribution layer, under-bump structure, and conductive connectors formed at subsequent stages, for example. The semiconductor die 202 may be formed from any suitable semiconductor material, such as silicon, germanium, gallium arsenide, gallium nitride, silicon nitride, silicon carbide, and the like. The semiconductor die 202 may further include any digital circuits, analog circuits, RF circuits, power circuits, memory, processor, MEMS, sensors, the like, and combinations thereof.

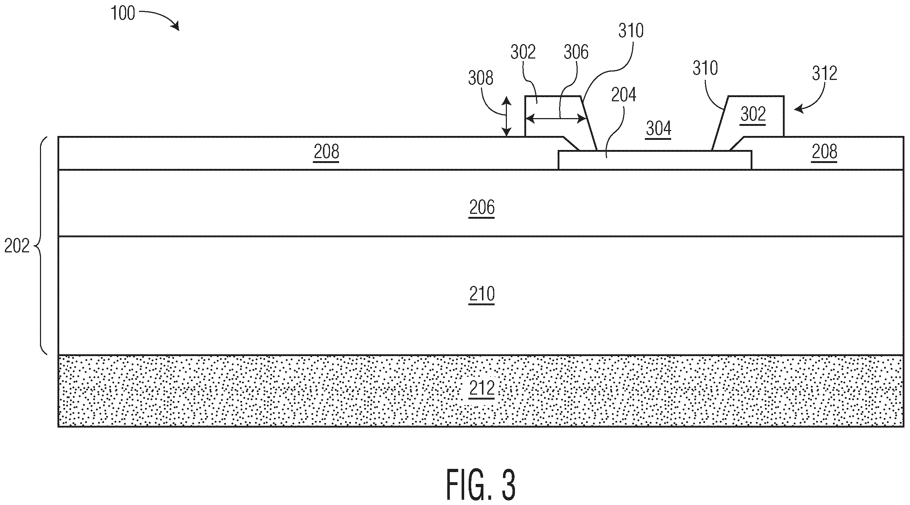

FIG. 3 illustrates, in a simplified cross-sectional view, the example semiconductor device 100 at a subsequent stage of manufacture in accordance with an embodiment. At this stage of manufacture, a first non-conductive (e.g., dielectric) layer 302 is formed over the semiconductor die 202. The non-conductive layer 302 is deposited or otherwise applied on the top surface of the semiconductor die 202. The non-conductive layer 302 may be formed from suitable non-conducting polymer materials such as polyimide, PBO, and the like, for example. In this embodiment, the non-conductive layer 302 may be formed from a non-sulfur (e.g., no sulfur or sulfur-based solvents) formulated polyimide material such as commercially available BL-301. In this embodiment, the non-conductive layer 302 is patterned to form a collar (e.g., ring) structure 312 having a central opening 304. The opening 304 is located directly over the bond pad 204 such that a substantial portion of the top surface of the bond pad 204 is exposed (e.g., not covered with the non-conductive layer 302). The non-sulfur formulated polyimide material is a desirable material for the collar structure 312 by providing higher thermal stability (e.g., resistance to forming reaction products at elevated temperatures) and minimizing potential electrochemical degradation of an RDL metal to bond pad interface over the usable life of the semiconductor device 100, for example.

The collar structure 312 is configured to surround an outer perimeter region of the bond pad 204. The collar structure 312 has an inner portion that directly contacts the top surface of the bond pad 204 and an inner sidewall 310 that surrounds the opening 304 exposing the top surface portion of the bond pad 204. An outer portion of the collar structure 312 may extend beyond an outer perimeter of the bond pad. The outer portion of the collar structure 312 which overlaps the passivation layer 208 of the semiconductor die 202 is configured to have a predetermined thickness dimension 308 measured from the top surface of the collar structure 312 to the top surface of the passivation layer 208. The collar structure 312 is further configured to have a predetermined width dimension 306 measured from the inner sidewall 310 to the outer perimeter of the collar structure 312. In this embodiment, the predetermined thickness dimension 308 is approximately equal to or greater than 5 microns and the predetermined width dimension 306 is approximately in a range of 5 microns to 20 microns.

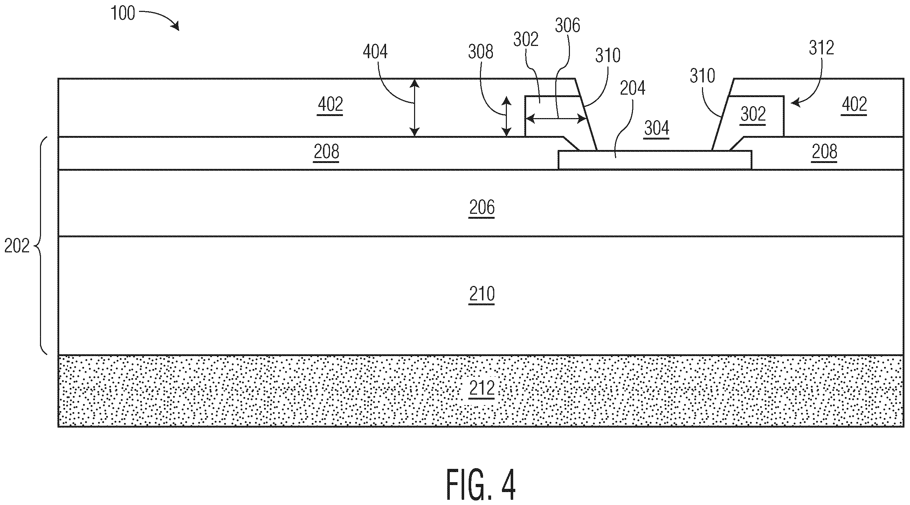

FIG. 4 illustrates, in a simplified cross-sectional view, the example semiconductor device 100 at a subsequent stage of manufacture in accordance with an embodiment. At this stage of manufacture, a second non-conductive (e.g., dielectric) layer 402 is formed over the first non-conductive layer 302 (e.g., patterned as the collar structure 312) and the exposed portions of the semiconductor die 202. The non-conductive layer 402 is deposited or otherwise applied on the collar structure 312 and on the top surface of the semiconductor die 202. In this embodiment, the non-conductive layer 402 is formed to have substantially planar top surface. The non-conductive layer 402 may be formed from suitable non-conducting polymer materials such as polyimide, PBO, and the like, for example. In this embodiment, the non-conductive layer 402 is formed having a different formulation that that of the first non-conductive layer 302. For example, the non-conductive layer 402 may be formulated having a mechanical property, such as an elongation property, higher than that of the non-conductive layer 302. It may be desirable for the non-conductive layer 402 to have a higher elongation mechanical property (e.g., greater than 50%) to mitigate possible stress between an UBM structure (formed at a subsequent stage) and portions of the semiconductor die 202, for example. In this embodiment, the non-conductive layer 402 may be formed from a polyimide material such as commercially available LTC9320.

The non-conductive layer 402 is patterned to form an opening through the non-conductive layer 402 such that the opening 304 is void of the non-conductive layer 402. The patterned opening through the non-conductive layer 402 is located directly over the bond pad 204 such that the substantial portion of the top surface of the bond pad 204 and inner sidewalls 310 of the of the collar structure 312 remain exposed. After the opening through the non-conductive layer 402 is formed, the collar structure 312 serves as an isolation barrier preventing the non-conductive layer 402 from directly contacting the top surface of the bond pad 204.

In this embodiment, a portion of the non-conductive layer 402 covers a top surface portion and outer sidewall portion of the collar structure 312. The portion of the non-conductive layer 402 which overlays the passivation layer 208 of the semiconductor die 202 is configured to have a predetermined thickness dimension 404 measured from the top surface of the non-conductive layer 402 to the top surface of the passivation layer 208. In this embodiment, the non-conductive layer 402 may be characterized as a thick dielectric layer having the predetermined thickness 404 approximately equal to or greater than 8 microns.

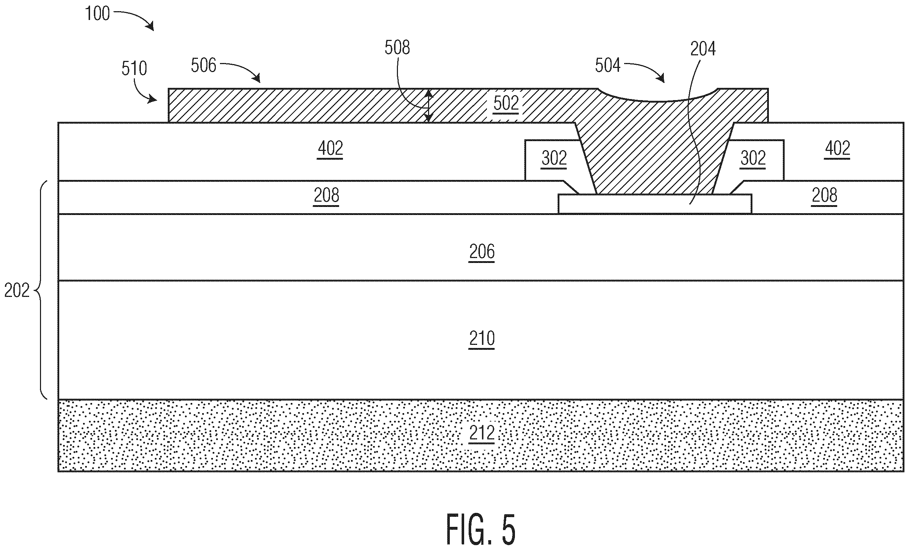

FIG. 5 illustrates, in a simplified cross-sectional view, the example semiconductor device 100 at a subsequent stage of manufacture in accordance with an embodiment. At this stage of manufacture, a metal RDL 502 is formed over the non-conductive layer 402 and exposed portion of the bond pad 204. The RDL 502 may be formed by way of sputtering or electroplating a metal material (e.g., copper), for example. The RDL 502 forms a conformal conductive layer on the exposed bond pad 204 in the opening 304 and portions of the non-conductive layer 402. The RDL 502 is conductively connected to the bond pad 204 and configured to interconnect the bond pad 204 with an under-bump structure formed at a subsequent stage, for example. The portion of the RDL 502 which overlays the non-conductive layer 402 is configured to have a predetermined thickness dimension 508 measured from the top surface of the RDL 502 to the top surface of the non-conductive layer 402. In this embodiment, the RDL 502 may be characterized as a thick metal RDL having the predetermined thickness 508 approximately equal to or greater than 8 microns. In this embodiment, it is desirable for the RDL 502 to be formed as a thick metal RDL to minimize resistance when the semiconductor device 100 is configured for high voltage (e.g., approximately 10 volts and higher) and/or high current (e.g., approximately 1 amp and higher) operation.

In this embodiment, the RLD 502 is patterned to form a plurality of RDL interconnection traces such as RDL interconnection trace 510 depicted in FIG. 5. The RDL interconnection trace 510 depicted in FIG. 5 may correspond to the RDL interconnection trace 106 depicted in FIG. 1, for example. In this embodiment, RDL interconnection trace 510 includes a first portion 504 directly connected to the top surface of the bond pad 204 and a second portion 506 configured as a base for formation of an UBM structure at a subsequent stage of manufacture.

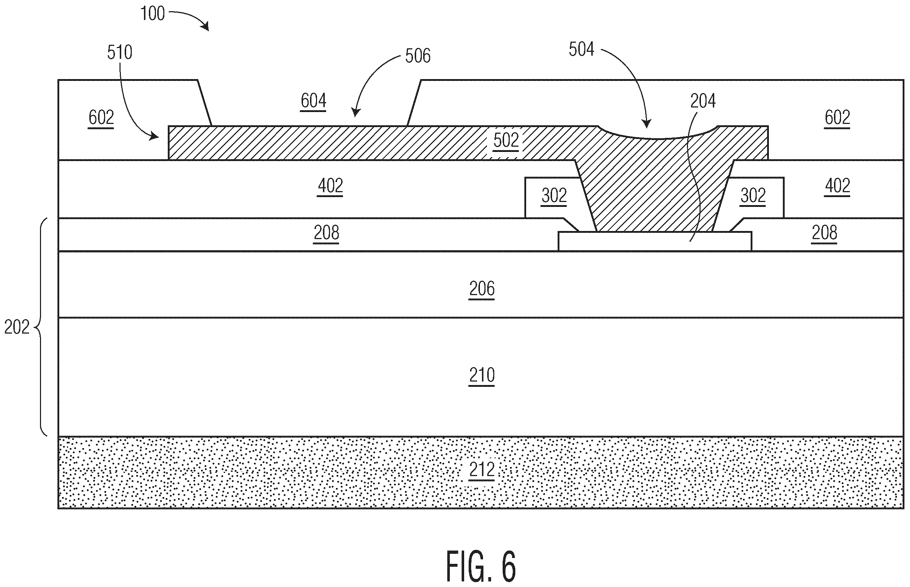

FIG. 6 illustrates, in a simplified cross-sectional view, the example semiconductor device 100 at a subsequent stage of manufacture in accordance with an embodiment. At this stage of manufacture, a non-conductive (e.g., dielectric) layer 602 is formed over the RDL 502 and the non-conductive layer 402. The non-conductive layer 602 is deposited or otherwise applied on the RDL 502 and the exposed top surface of the non-conductive layer 402. The non-conductive layer 602 may be formed from suitable non-conducting materials such as PBO, polyimide, ABF, and epoxy molding compound, for example. In this embodiment, the non-conductive layer 602 may be characterized as a photo-imageable polymer material (e.g., photosensitive solder mask material) layer. In this embodiment, the non-conductive layer 602 is patterned to form an opening 604 through the non-conductive layer 602 such that a top surface portion (e.g., second portion 506) of the RDL interconnection trace 510 is exposed through the opening 604.

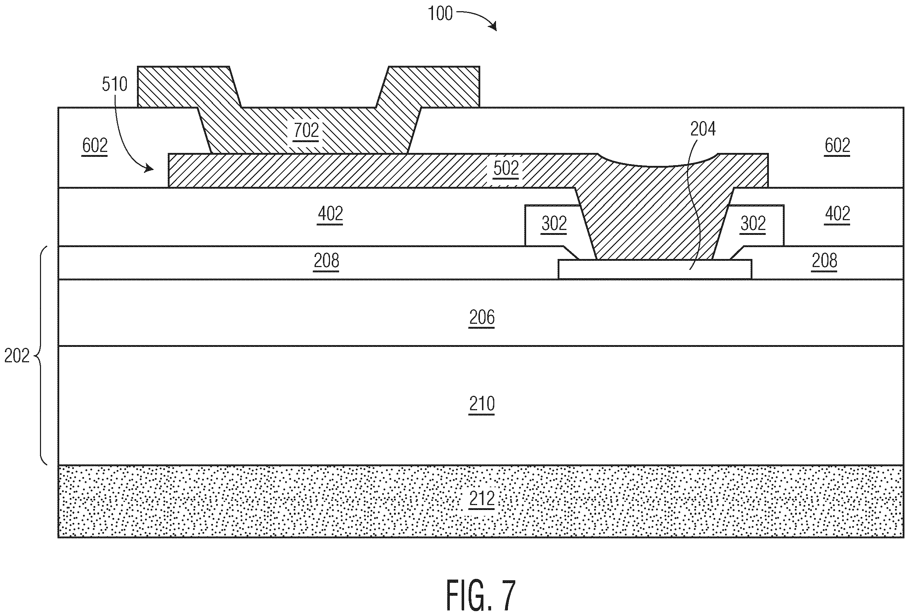

FIG. 7 illustrates, in a simplified cross-sectional view, the example semiconductor device 100 at a subsequent stage of manufacture in accordance with an embodiment. At this stage of manufacture, a metal (e.g., copper) UBM structure 702 is formed on the exposed portion of the RDL interconnection trace 510. In this embodiment, the UBM structure 702 maybe formed by way of a plating process. For example, a seed layer (not shown) may be formed and patterned over the exposed portion of the RDL interconnection trace 510 in the opening 604 (FIG. 6). The UBM structure 702 may be formed by utilizing the patterned seed layer in the plating process. The UBM structure 702 forms a conformal conductive layer over the exposed portion of the RDL interconnection trace 510 and sidewalls of the opening 604 (FIG. 6). The UBM structure 702 is conductively interconnected with the bond pad by way of the RDL interconnection trace 510. In other embodiments, the UBM structure 702 may be formed by plating or otherwise depositing other metal materials.

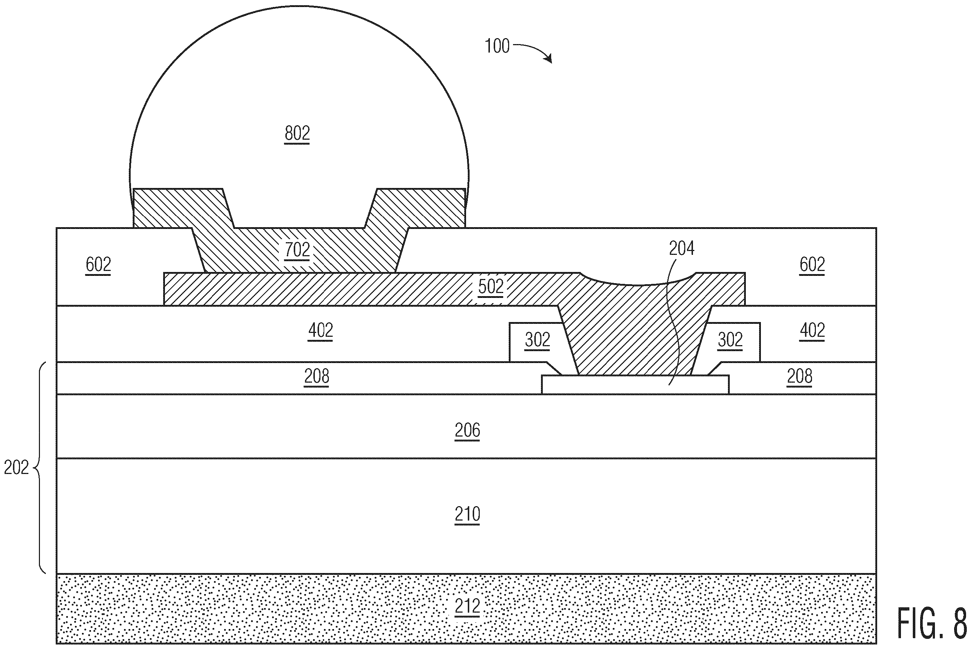

FIG. 8 illustrates, in a simplified cross-sectional view, the example semiconductor device 100 at a subsequent stage of manufacture in accordance with an embodiment. At this stage of manufacture, a conductive connector 802 (e.g., solder ball) is attached to UBM structure 702. The conductive connector 802 is placed onto the UBM structure 702 and reflowed, for example. A flux material (not shown) may be placed on the UBM structure 702 before placing the conductive connector 802 onto the UBM structure 702 to improve wetting and adhesion. In this embodiment, the conductive connector 802 is formed as a solder ball. In other embodiments, the conductive connector 802 may be formed as a solder bump, gold stud, copper pillar, or the like.

Generally, there is provided, a method including forming a first non-conductive layer over a top side a semiconductor die; patterning the first non-conductive layer to form a collar structure surrounding an opening exposing a top surface of a bond pad of the semiconductor die; forming a second non-conductive layer over the first non-conductive layer and exposed portions of the top side of the semiconductor die, the second non-conductive layer different from the first non-conductive layer; patterning the second non-conductive layer to expose the top surface of the bond pad and inner sidewalls of the of the collar structure surrounding the opening such that the second non-conductive layer does not contact the bond pad; and forming a metal redistribution layer (RDL) over the second non-conductive layer and exposed top surface of the bond pad. The first non-conductive layer may be characterized as a polyimide material formulated without sulfur. The RDL may be characterized as a thick metal RDL having a thickness approximately equal to or greater than 8 microns. The collar structure surrounding the opening may have an inner portion that directly contacts the top surface of the bond pad and an outer portion that extends beyond an outer perimeter of the bond pad. A portion of the collar structure formed over a passivation layer of the semiconductor die may have a thickness approximately equal to or greater than 5 microns. The forming the RDL may include forming a plurality of patterned RDL interconnection traces, a first RDL interconnection trace of the plurality includes a first portion directly connected to the top surface of the bond pad. The method may further include forming an under-bump metallization (UBM) structure on a second portion of the first RDL interconnection trace, the UBM structure conductively interconnected with the bond pad by way of the first RDL interconnection trace. The forming the RDL may include forming the RDL by way of sputtering or electroplating a copper material. The second non-conductive layer may be formed having a thickness greater than that of the first non-conductive layer.

In another embodiment, there is provided, a semiconductor device including a collar structure formed from a first non-conductive material, the collar structure surrounding an opening exposing a top surface of a bond pad of a semiconductor die; a second non-conductive material formed as a layer covering the collar structure and the top side of the semiconductor die, the second non-conductive material different from the first non-conductive material; an opening through the second non-conductive layer exposes the top surface of the bond pad and inner sidewalls of the of the collar structure surrounding the opening such that the second non-conductive layer does not contact the bond pad; and a metal redistribution layer (RDL) formed over the second non-conductive layer and exposed top surface of the bond pad. The RDL may include a plurality of RDL interconnection traces, a first RDL interconnection trace of the plurality having a first portion directly connected to the top surface of the bond pad and an under-bump metallization (UBM) structure formed on a second portion of the first RDL interconnection trace, the UBM structure conductively interconnected with the bond pad by way of the first RDL interconnection trace. The collar structure may have an inner portion that directly contacts the top surface of the bond pad and an outer portion that extends beyond an outer perimeter of the bond pad. The collar structure may serve as an isolation barrier that prevents the second non-conductive layer from directly contacting the top surface of the bond pad. The RDL may be characterized as a thick metal RDL having a thickness approximately equal to or greater than 8 microns. The second non-conductive material may be characterized as a polyimide material having a substantially planar top surface.

In yet another embodiment, there is provided, a method including forming a first non-conductive layer over a top side a semiconductor die; patterning the first non-conductive layer to form a collar structure surrounding an opening exposing a top surface of a bond pad of the semiconductor die; forming a second non-conductive layer over the first non-conductive layer and exposed portions of the top side of the semiconductor die, the second non-conductive layer having a mechanical property different from that of the first non-conductive layer; patterning the second non-conductive layer to expose the top surface of the bond pad and inner sidewalls of the of the collar structure surrounding the opening such that the second non-conductive layer does not contact the bond pad; and forming a metal redistribution layer (RDL) over the second non-conductive layer and exposed top surface of the bond pad. The forming the RDL may include forming a plurality of patterned RDL interconnection traces, a first RDL interconnection trace of the plurality having a first portion directly connected to the top surface of the bond pad. The method may further include forming an under-bump metallization (UBM) structure on a second portion of the first RDL interconnection trace, the UBM structure conductively interconnected with the bond pad by way of the first RDL interconnection trace. The collar structure may have an inner portion that directly contacts the top surface of the bond pad and an outer portion that extends beyond an outer perimeter of the bond pad, the collar structure configured to serve as an isolation barrier preventing the second non-conductive layer from directly contacting the top surface of the bond pad. The mechanical property may be characterized as an elongation property, the second non-conductive layer having an elongation property higher than that of the first non-conductive layer.

By now, it should be appreciated that there has been provided a semiconductor device with a redistribution layer. The semiconductor device includes a first non-conductive layer formed over a top passivation layer of a semiconductor die. The first non-conductive layer is patterned to form a collar structure surrounding an outer perimeter of an opening that exposes a top surface portion of a bond pad of the semiconductor die. The collar structure has an inner portion that contacts an outer region of the exposed bond pad surface and an outer portion that extends beyond the outer perimeter of the opening. The semiconductor device further includes a second non-conductive layer formed over the collar structure and exposed surface of the top of the semiconductor die. The second non-conductive layer is formed having a different formulation that that of the first non-conductive layer. For example, the first non-conductive layer may be formulated without sulfur or sulfur-based solvents. The second non-conductive layer is patterned to expose the top surface portion of the bond pad and inner sidewalls of the of the collar structure surrounding the opening. The collar structure is configured to prevent the second non-conductive layer from directly contacting the top surface of the bond pad. A conductive redistribution layer is formed over the patterned second non-conductive layer and exposed top surface of the bond pad such that a portion of an interconnecting trace is directly connected to the bond pad through the opening. By forming the redistribution layer bond pad connection with the surrounding collar structure in this manner, the semiconductor device can operate at higher voltages and exhibit superior reliability.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a first non-conductive layer over a top side a semiconductor die;
patterning the first non-conductive layer to form a collar structure surrounding an opening exposing a top surface of a bond pad of the semiconductor die;
forming a second non-conductive layer over the first non-conductive layer and exposed portions of the top side of the semiconductor die, the second non-conductive layer different from the first non-conductive layer;
patterning the second non-conductive layer to expose the top surface of the bond pad and inner sidewalls of the of the collar structure surrounding the opening such that the second non-conductive layer does not contact the bond pad; and
forming a metal redistribution layer, RDL, over the second non-conductive layer and exposed top surface of the bond pad.

2. The method of claim 1, wherein the first non-conductive layer is characterized as a polyimide material formulated without sulfur.

3. The method of claim 1 or 2, wherein the RDL is characterized as a thick metal RDL having a thickness approximately equal to or greater than 8 microns.

4. The method of any preceding claim, wherein the collar structure surrounding the opening has an inner portion that directly contacts the top surface of the bond pad and an outer portion that extends beyond an outer perimeter of the bond pad.

5. The method of any preceding claim, wherein a portion of the collar structure formed over a passivation layer of the semiconductor die has a thickness approximately equal to or greater than 5 microns.

6. The method of any preceding claim, wherein the forming the RDL includes forming a plurality of patterned RDL interconnection traces, a first RDL interconnection trace of the plurality includes a first portion directly connected to the top surface of the bond pad.

7. The method of claim 6, further comprising forming an under-bump metallization (UBM) structure on a second portion of the first RDL interconnection trace, the UBM structure conductively interconnected with the bond pad by way of the first RDL interconnection trace.

8. The method of any preceding claim, wherein the forming the RDL includes forming the RDL by way of sputtering or electroplating a copper material.

9. The method of any preceding claim, wherein the second non-conductive layer is formed having a thickness greater than that of the first non-conductive layer.

10. A semiconductor device comprising:
a collar structure formed from a first non-conductive material, the collar structure surrounding an opening exposing a top surface of a bond pad of a semiconductor die;
a second non-conductive material formed as a layer covering the collar structure and the top side of the semiconductor die, the second non-conductive material different from the first non-conductive material;
an opening through the second non-conductive layer exposes the top surface of the bond pad and inner sidewalls of the of the collar structure surrounding the opening such that the second non-conductive layer does not contact the bond pad; and
a metal redistribution layer, RDL, formed over the second non-conductive layer and exposed top surface of the bond pad.

11. The semiconductor device of claim 10, wherein the RDL includes a plurality of RDL interconnection traces, a first RDL interconnection trace of the plurality having a first portion directly connected to the top surface of the bond pad and an under-bump metallization (UBM) structure formed on a second portion of the first RDL interconnection trace, the UBM structure conductively interconnected with the bond pad by way of the first RDL interconnection trace.

12. The semiconductor device of claim 10 or 11, wherein the collar structure has an inner portion that directly contacts the top surface of the bond pad and an outer portion that extends beyond an outer perimeter of the bond pad.

13. The semiconductor device of any of claims 10 to 12, wherein the collar structure serves as an isolation barrier that prevents the second non-conductive layer from directly contacting the top surface of the bond pad.

14. The semiconductor device of any of claim 10 to 13, wherein the RDL is characterized as a thick metal RDL having a thickness approximately equal to or greater than 8 microns.

15. The semiconductor device of any of claim 10 to 14, wherein the second non-conductive material is characterized as a polyimide material having a substantially planar top surface.
